Europäisches Patentamt

European Patent Office

Office européen des brevets

(19)

(11) Veröffentlichungsnummer: **0 080 242**
**A1**

# (12) EUROPÄISCHE PATENTANMELDUNG

(21) Anmeldenummer: **82201475.9**

(22) Anmeldetag: **19.11.82**

(51) Int. Cl.³: **H 03 F 3/45**, H 01 L 27/08

(30) Priorität: **23.11.81 DE 3146357**

(43) Veröffentlichungstag der Anmeldung: **01.06.83**
**Patentblatt 83/22**

(84) Benannte Vertragsstaaten: **DE FR GB**

(71) Anmelder: **Philips Patentverwaltung GmbH,**
**Steindamm 94, D-2000 Hamburg 1 (DE)**

(84) Benannte Vertragsstaaten: **DE**

(71) Anmelder: **N.V. Philips' Gloeilampenfabrieken,**
**Groenewoudseweg 1, NL-5621 BA Eindhoven (NL)**

(84) Benannte Vertragsstaaten: **FR GB**

(72) Erfinder: **Gottlieb, Detlef, Appener Weg 3A,**
**D-2000 Hamburg 20 (DE)**

(74) Vertreter: **Hartmann, Heinrich, Dipl.-Ing. et al, Philips**
**Patentverwaltung GmbH Steindamm 94,**
**D-2000 Hamburg 1 (DE)**

(54) Verstärkerschaltung mit einer symmetrisch aufgebauten Eingangsstufe.

(57) Bei Verstärkern mit symmetrisch aufgebauter Differenzverstärker-Eingangsstufe kann durch einen Ruhestrom über einen mit einem der beiden Eingänge verbundenen Vorwiderstand (8) ein Eingangsspannungs-Offset auftreten. Dieser Eingangsspannungs-Offset kann, insbesondere bei integrierten Schaltungen, dadurch verringert bzw. kompensiert werden, daß ein Transistor des Zweiges der Differenzverstärker-Eingangsstufe, mit dem der Vorwiderstand verbunden ist, eine größere Emitterfläche erhält als der entsprechende Transistor des anderen Zweiges.

ACTORUM AG

Verstärkerschaltung mit einer symmetrisch aufgebauten
Eingangsstufe

Die Erfindung bezieht sich auf eine Verstärkerschaltung
mit einer zwei Zweige mit einander entsprechendem Aufbau
enthaltenden Differenzverstärker-Eingangsstufe, bei der
ein Ruhestrom über einen Vorwiderstand an einem der beiden
Eingänge fließt.

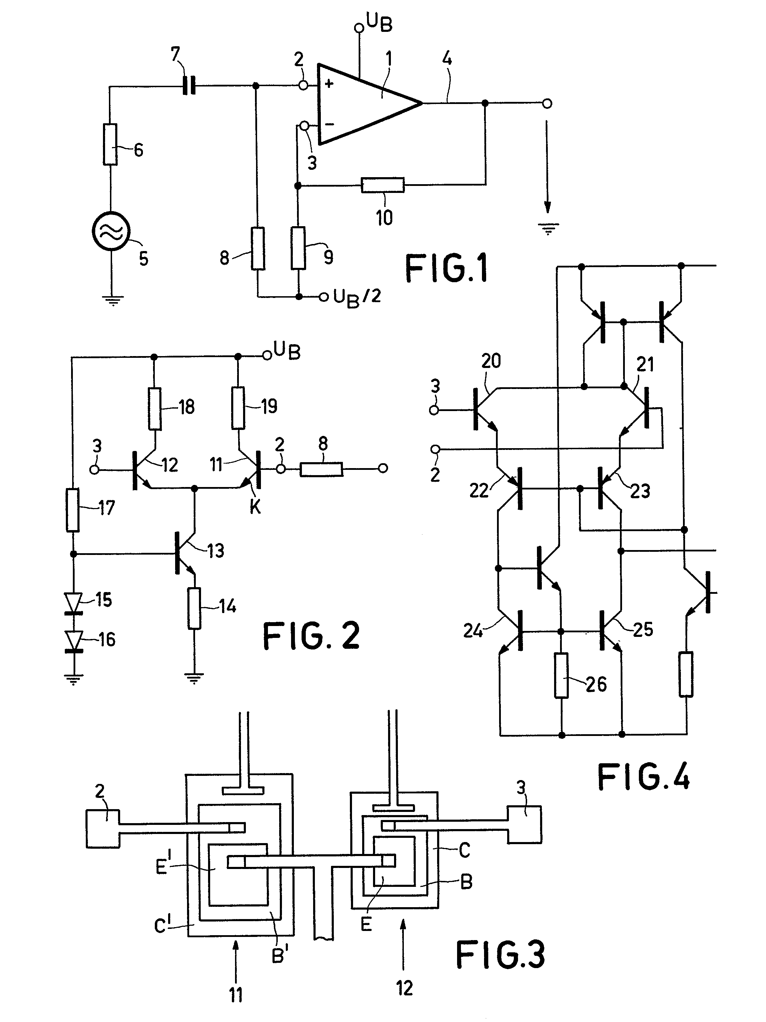

Operationsverstärker haben meist eine solche symmetrisch
aufgebaute Differenzverstärker-Eingangsstufe. In Fig. 1
ist ein mit Hilfe eines solchen Operationsverstärkers
aufgebauter Wechselspannungsverstärker dargestellt. Kern
dieses Wechselspannungsverstärkers ist ein Operationsverstärker 1 mit einem nicht invertierenden Eingang 2 und
einem invertierenden Eingang 3 sowie einem Ausgang 4. Das
zu verstärkende Signal wird von einer Signalquelle 5 mit
einem Innenwiderstand 6 geliefert, deren einer Anschluß
mit Masse und deren anderer Anschluß über einen Kondensator 7
mit dem nicht invertierenden Eingang 2 des Operationsverstärkers 1 verbunden ist. Der Ruhestrom für diesen Eingang
wird über einen Vorwiderstand 8 von einer Gleichspannungsquelle erzeugt, deren Gleichspannung $U_B/2$ halb so groß
ist wie die dem Operationsverstärker zugeführte Versorgungsspannung $U_B$. Diese Gleichspannungsquelle ist über einen
Widerstand 9 mit dem invertierenden Eingang 3 verbunden,
der zugleich über einen Widerstand 10 mit dem Ausgang 4
des Verstärkers verbunden ist.

Die Verstärkung dieses Wechselspannungsverstärkers hängt
von dem Verhältnis der Widerstände 9 und 10 ab; je größer
der Widerstand 10 im Vergleich zum Widerstand 9 ist, um
so höher ist die Verstärkung. Der Widerstand der Parallelschaltung aus den beiden Widerständen 9 und 10 soll in der Praxis klein im Vergleich zum Innenwiderstand 6 der Signalspannungsquelle sein, während der Vorwiderstand 8 groß im Vergleich zur Wechselspannungsquelle sein soll, damit er für die Wechselspannungsverstärkung 8 praktisch nicht wirksam ist.

Der über den Widerstand 8 zum nicht invertierenden Eingang 2 fließende Ruhestrom erzeugt am Widerstand 8 einen Spannungsabfall, dem am invertierenden Eingang 3 kein gleichwertiger Spannungsabfall gegenübersteht, weil der Widerstand der Parallelschaltung aus den Widerständen 9 und 10 gegenüber dem Vorwiderstand 8 vernachlässigbar klein ist und der Ruhestrom am invertierenden Eingang etwa genau so groß ist wie der Ruhestrom am nicht invertierenden Eingang. Infolgedessen resultiert am Eingang ein störender Spannungs-Offset, der dazu führt, daß das Ruhepotential am nicht invertierenden Eingang 2 positiver bzw. negativer ist als am invertierenden Eingang 3, je nachdem wie die Eingangsstufe des Operationsverstärkers aufgebaut ist bzw. in welcher Richtung der Ruhestrom den Widerstand 8 durchfließt.

Grundsätzlich könnte dieser Eingangsspannungs-Offset auf verschiedene Weise beseitigt werden:

a) Die Eingangsstufe im Operationsverstärker wird so ausgelegt, daß nur noch ein so kleiner Eingangsruhestrom erforderlich ist, daß der Eingangsspannungs-Offset vernachlässigbar klein ist. Dies ist jedoch nicht immer möglich, weil rauscharme Operationsverstärker mit bipolaren Transistoren einen relativ großen Eingangsruhestrom (in der Größenordnung von einigen 100 nA) erfordern.

b) Eine andere Möglichkeit, den Eingangsspannungs-Offset
klein zu halten, bestünde darin, zwischen den invertierenden Eingang 3 und den Verbindungspunkt der Widerstände 9 und 10 einen Widerstand zu schalten, der so
bemessen ist, daß der an ihm vom Ruhestrom erzeugte
Spannungsabfall zusammen mit dem durch den Ruhestrom
an der Parallelschaltung der Widerstände 9 und 10 erzeugten Spannungsabfall gerade ausreicht, um den vom
Ruhestrom des nicht invertierenden Einganges am Widerstand 8 erzeugten Spannungsabfall zu kompensieren.
Dieser Widerstand dürfte dann nur geringfügig kleiner
sein als der Vorwiderstand 8. Ein derart großer Widerstand verschlechtert die Rauscheigenschaften des
Wechselspannungsverstärkers aber erheblich.

Aufgabe der vorliegenden Erfindung ist es, den Eingangsspannungs-Offset bei einer insbesondere in integrierter
Schaltungstechnik ausgeführten Verstärkerschaltung der
eingangs genannten Art zu kompensieren, zumindest aber
zu verringern, praktisch ohne zusätzlichen Aufwand und
ohne die Rauscheigenschaften der Verstärkerschaltung zu
verschlechtern.

Diese Aufgabe wird erfindungsgemäß dadurch gelöst, daß
wenigstens ein Transistor des mit dem Widerstand gekoppelten Zweiges der Differenzverstärkerschaltung eine größere
Fläche hat als der entsprechende Transistor im anderen Zweig.

Die Erfindung nutzt die Tatsache aus, daß bei gleichem
Ruhestrom, d.h. bei gleichem Emitterstrom, die Basis-
Emitter-Spannung eines Transistors um so kleiner sein
kann, je größer dessen Emitterfläche ist. Wird die Emitterfläche soweit vergrößert, daß die dadurch bewirkte Abnahme
der Basis-Emitter-Spannung wenigstens annähernd dem Spannungsabfall am Vorwiderstand entspricht, wird der Eingangsspannungs-Offset verringert bzw. kompensiert.

Aufgrund unvermeidlicher Fertigungsstreuungen lassen sich
integrierte Schaltungen nicht so herstellen, daß die
Eingangs-Offsetspannung exakt kompensiert wird. Der Einfluß von Fertigungsstreuungen läßt sich jedoch nach einer
Weiterbildung der Erfindung, die von einer den Ruhestrom
in den beiden Zweigen der Differenzverstärkerstufe mit
Hilfe eines Widerstandes bestimmenden Stromquelle ausgeht,
dadurch verringern, daß die Stromquelle einen Widerstand
enthält und so ausgebildet ist, daß das Produkt aus Ruhestrom und Widerstand konstant ist, und daß der Vorwiderstand ebenfalls in integrierter Schaltungstechnik ausgeführt und auf gleiche Weise hergestellt ist wie der Widerstand der Stromquelle. Eine besonders geringe Abhängigkeit
von Fertigungsstreuungen ergibt sich nach einer Weiterbildung der Erfindung dadurch, daß der Vorwiderstand als vergrabener Widerstand ausgebildet ist.

Die Erfindung wird nachstehend anhand der Zeichnung näher
erläutert. Es zeigen
    Fig. 1 einen Wechselspannungsverstärker, bei dem durch
           einen Vorwiderstand ein Eingangsspannungs-Offset
           hervorgerufen wird,
    Fig. 2 eine bei Operationsverstärkern übliche Eingangsstufe,
    Fig. 3 eine Aufsicht auf einen Halbleiterkristall mit
           einem Teil der erfindungsgemäßen Schaltung, und
    Fig. 4 eine weitere Eingangsstufe, bei der die Erfindung
           ebenfalls anwendbar ist.

Die in Fig. 2 dargestellte Eingangsstufe eines Operationsverstärkers umfaßt zwei Transistoren 11 und 12, deren
Emitter miteinander verbunden sind und deren Basisanschlüsse
den nicht invertierenden Eingang 2 bzw. den invertierenden Eingang 3 bilden. In die gemeinsame Emitterzuleitung der
bipolaren npn-Transistoren 11 und 12 ist eine Gleichstromquelle aufgenommen, die aus der Kollektor-Emitter-Strecke
eines Transistors 13 mit einem Emitter-Widerstand 14 besteht, dessen eines Ende mit Masse verbunden ist. Die Basis
des Transistors 13 ist mit der Serienschaltung zweier
in Durchlaßrichtung betriebener Dioden 15 und 16 verbunden,
deren einer Anschluß an Masse angeschlossen ist und deren
anderer Anschluß über einen Widerstand 17 mit der positiven
Versorgungsspannung $U_B$ verbunden ist. Das dem Eingang 2
bzw. 3 zugeführte Signal wird auf nicht näher dargestellte
Weise an den Kollektoren der Transistoren 11 und 12, die
über Widerstände 18 bzw. 19 mit der positiven Versorgungsspannung $U_B$ verbunden sind, abgenommen und weiterverstärkt.

Solche Eingangsstufen, soweit bisher beschrieben, sind bei
Operationsverstärkern bekannt.

Erfindungsgemäß besitzen die Transistoren unterschiedliche
Emitterflächen, wie insbesondere Fig. 3 zeigt, die einen
Ausschnitt aus einem Halbleiterkristall einer integrierten
Schaltung zeigt, der nur die beiden Transistoren 11 und
12 umfaßt. Jeder Transistor umfaßt eine n-dotierte Kollektorzone C' bzw. C, die eine p-dotierte Basiszone B' bzw. B
umschließt, in der eine n-dotierte Emitterzone E' bzw. E
angeordnet ist. Jede Zone ist mit Leitbahnen versehen, wobei
die mit den Basiszonen B' bzw. B verbundenen Leitbahnen
zu den äußeren Anschlußpunkten (pins) 2 bzw. 3 führen und
die beiden Emitterzonen E bzw. E' über eine Leitbahn miteinander verbunden sind. Erfindungsgemäß ist die Emitterzone E' des Transistors 11 größer als die Emitterzone E
des Transistors 12.

Für diese Anordnung gilt die Gleichung

$$U_{B'E'} - U_{BE} = u_T \ln j_1/j_2 \tag{1}$$

Dabei ist $U_{B'E'}$ die Basis-Emitter-Vorspannung des Transistors 11, $U_{BE}$ die Basis-Emitter-Vorspannung des Transistors 12, $u_T$ die Temperaturspannung ($\sim$26 mV bei Zimmertemperatur) und $j_1$ bzw. $j_2$ die Emitter-Stromdichte der beiden Transistoren 11 und 12. Wenn die Emitter-Ströme gleich sind, ist die Differenz negativ und proportional zum Logarithmus des Quotienten aus den Emitterflächen. Bei geeigneter Bemessung gilt dann die Beziehung

$$I \cdot R = R \cdot I_0/2 \, \beta = u_T \ln k \qquad (2)$$

Dabei ist R der Widerstandswert des Widerstandes 8, I der darüber fließende Ruhestrom (= Basisstrom des Transistors 11), k ein Faktor ($> 1$), der angibt, um wieviel mal größer die Emitterfläche des Transistors 11 ist als die des Transistors 12, $I_0$ der von der Gleichstromquelle 13 gelieferte Gleichstrom und $\beta$ der Stromverstärkungsfaktor. Ist k kleiner als in Gleichung (2) angegeben, erfolgt keine vollständige Kompensation der Offset-Spannung, ist k größer als in Gleichung (2) angegeben, erfolgt eine Überkompensation; in der Regel ist dabei aber der Eingangsspannungs-Offset verringert. Beträgt beispielsweise der Ruhestrom 360 nA und der Widerstand 8 50 kOhm, dann muß die Emitterfläche des Transistors 11 doppelt so groß sein wie die des Transistors 12, damit der Eingangsspannungs-Offset kompensiert wird.

Aus Gleichung (2) wird erkennbar, daß der Eingangsspannungs-Offset u.a. dem Gleichstrom der Stromquelle 13, 14 proportional ist. Dieser Wert ist bei der Herstellung Streuungen unterworfen, die dazu führen, daß Gleichung (2) in der Praxis nicht exakt erfüllt werden kann. Diese Streuungen werden u.a. durch die Streuungen des Widerstandes 14 in Fig. 2 bestimmt. Der Strom $I_0$ ist diesem Widerstand umgekehrt proportional. Wenn nun auch der Widerstand 8 in integrierter Schaltungstechnik ausgeführt und in gleicher Weise hergestellt wird wie der Widerstand 14 (als nicht vergrabener Widerstand), hebt sich der Einfluß der Streuungen dieser Widerstände auf das Produkt R $I_0$ auf, weil das Verhältnis dieser Widerstände weitgehend unabhängig von Fertigungsstreuungen ist.

Jedoch wird auch in einem solchen Fall die durch den Ruhestrom hervorgerufene Eingangs-Offsetspannung noch relativ stark von Streuungen betroffen, weil der Stromverstärkungsfaktor $\beta$ noch stärker streuen kann als die integrierten Widerstände 8 und 14 - wenn diese als nicht vergrabene Widerstände ausgeführt sind.

Von besonderem Vorteil ist es daher, wenn der Widerstand 8 als vergrabener Widerstand ausgeführt wird. Der Wert eines solchen vergrabenen Widerstandes ist zwar noch stärkeren Streuungen unterworfen als ein nur durch einen einzigen Diffusionsprozeß hergestellter integrierter Widerstand, jedoch bedingt es das Herstellungsverfahren, daß der Stromverstärkungsfaktor $\beta$ sich dabei so ändert, daß das Produkt R/$\beta$ praktisch konstant bleibt. Der Eingangs-Spannungsoffset wird dann praktisch nur noch durch Streuungen des Gleichstroms $I_0$ bestimmt.

Fig. 4 zeigt eine andere bei Operationsverstärkern übliche Eingangsstufe, bei der die Erfindung ebenfalls anwendbar ist. Diese Eingangsstufe enthält zwei Transistoren 20 und 21, deren Kollektoren miteinander verbunden sind und deren Basiselektroden den invertierenden Eingang 3 bzw. den nicht invertierenden Eingang 2 bilden. Die Emitter dieser beiden npn-Transistoren sind jeweils mit dem Emitter eines pnp-Transistors 22 bzw. 23 verbunden, deren Basen miteinander verbunden sind und deren Kollektoren mit den Kollektoren zweier npn-Transistoren 24 bzw. 25 verbunden sind, deren Basis- und Emitterelektroden miteinander verbunden sind, wobei zwischen Basis und Emitter ein Wider-

stand 26 geschaltet ist. Der weitere Aufbau dieser Eingangsstufe hat für die Erfindung keine Bedeutung und ist im übrigen bekannt (vgl. z.B. Valvo-Handbuch "Integrierte Linearschaltungen"1971, Operationsverstärker TBA 222).

Die Eingangsstufe besteht somit aus zwei symmetrisch angeordneten Zweigen 20, 22 und 24 bzw. 21, 23 und 25. Der Eingangsspannungs-Offset, der durch den Eingangsruhestrom an einen mit dem Eingang 2 verbundenen Vorwiderstand verursacht wird, kann dabei dadurch beseitigt bzw. verringert werden, daß die Emitterfläche des Transistors 21 entsprechend Gleichung (2) größer gemacht wird als die des Transistors 20. Ebenso kann der Offset dadurch kompensiert werden, daß die Emitterfläche des Transistors 23 gegenüber der des Transistors 22 vergrößert wird. Gegebenenfalls können auch beide Emitterflächen 21 und 23 zusammen gegenüber den Emitterflächen der Transistoren 20 und 22 vergrößert werden.

Es ist ohne weiteres erkennbar, daß eine Änderung der Emitterfläche des Transistors 25 auf den Eingangsspannungs- Offset praktisch keine Auswirkungen hat. Es dürfen nämlich nur die Emitterflächen derjenigen Transistoren vergrößert werden, deren Basis-Emitter-Strecken in Serie mit den Basis-Emitter-Strecken der entsprechenden Transistoren des anderen Zweiges zwischen den beiden Eingangsklemmen liegen. Dies gilt auch für anders aufgebaute Eingangsstufen.

Auch bei Verstärkern mit anders aufgebauten Eingangsstufen, z.B. mit einem Darlington-Differenzverstärker, wie er bei der integrierten Schaltung TDA 1078 benutzt wird (Valvo- Handbuch "Professionelle Integrierte Analog- und Spezial- Schaltungen"), ist die Erfindung anwendbar.

PATENTANSPRÜCHE:

1.　Verstärkerschaltung mit einer zwei Zweige mit einander entsprechendem Aufbau enthaltenden Differenzverstärker-Eingangsstufe, bei der ein Ruhestrom über einen Vorwiderstand an einem der beiden Eingänge fließt, dadurch gekennzeichnet, daß wenigstens ein Transistor (11; 21, 23) des mit dem Widerstand (8) gekoppelten Zweiges der Differenzverstärkerschaltung eine größere Emitterfläche hat als der entsprechende Transistor im anderen Zweig (12; 20, 22).

2.　Verstärkerschaltung nach Anspruch 1, die als integrierte Schaltung ausgeführt ist mit einer den Ruhestrom in den beiden Zweigen der Differenzverstärker-Eingangsstufe bestimmenden Stromquelle, dadurch gekennzeichnet, daß die Stromquelle einen Widerstand (14) enthält und so ausgebildet ist, daß das Produkt aus Ruhestrom ($I_0$) und Widerstand konstant ist, und daß der Vorwiderstand (8) ebenfalls in integrierter Schaltungstechnik ausgeführt und auf gleiche Weise hergestellt ist wie der Widerstand der Stromquelle.

3.　Verstärkerschaltung nach Anspruch 1, die als integrierte Schaltung ausgeführt ist, dadurch gekennzeichnet, daß der Vorwiderstand (8) als vergrabener Widerstand ausgebildet ist.

0080242

FIG.1

FIG. 2

FIG.3

FIG.4

0080242

EUROPÄISCHER RECHERCHENBERICHT

Nummer der Anmeldung

EP 82 20 1475

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | --- <br> Patent Abstract of Japan Band 5, Nr. 3, 10. Januar 1981 <br> & JP-A-55-133563 | | H 03 F 3/45 <br> H 01 L 27/08 |
| A | --- <br> US-A-4 116 732 (J.S. SHIER) <br> * Zusammenfassung * | 3 | |
| A | --- <br> US-A-4 210 875 (J.D. BEASOM) <br><br> * Figuren 1, 2 * | | |
| A | --- <br> US-A-4 207 536 (P.H. LEWIS) <br><br> * Figur 1 * | | |
| A | --- <br> US-A-3 761 787 (W.R. DAVIS et al.) <br> * Figur 1 * | | |
| | ----- | | |

RECHERCHIERTE SACHGEBIETE (Int. Cl. ³)

H 01 L 23/56
H 01 L 27/08
H 03 F 3/45

Der vorliegende Recherchenbericht wurde für alle Patentansprüche erstellt.

| Recherchenort <br> BERLIN | Abschlußdatum der Recherche <br> 31-01-1983 | Prüfer <br> BREUSING J |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03.82